# EUROPÄISCHE PATENTSCHRIFT

(11) **EP 4 099 555 B1**
(45) Veröffentlichungstag und Bekanntmachung des Hinweises auf die Patenterteilung: **06.08.2025**
(21) Anmeldenummer: 22176630.6
(22) Anmeldetag: 01.06.2022
(51) Int. Cl.: H02M 7/00, H02M 7/48, H01L 25/07, H01R 25/16, H02B 1/20, H02K 11/33

(54) **HALBBRÜCKE FÜR EINEN ELEKTRISCHEN ANTRIEB EINES ELEKTROFAHRZEUGS ODER EINES HYBRIDFAHRZEUGS, LEISTUNGSMODUL FÜR EINEN INVERTER UND INVERTER**
HALF BRIDGE FOR AN ELECTRIC DRIVE OF AN ELECTRIC VEHICLE OR A HYBRID VEHICLE, POWER MODULE FOR AN INVERTER AND INVERTER
DEMI-PONT POUR UN ENTRAÎNEMENT ÉLECTRIQUE D'UN VÉHICULE ÉLECTRIQUE OU D'UN VÉHICULE HYBRIDE, MODULE DE PUISSANCE POUR UN ONDULEUR ET ONDULEUR

(30) Priorität: 02.06.2021 DE 102021205632
(43) Veröffentlichungstag der Anmeldung: 07.12.2022
(73) Patentinhaber: ZF Friedrichshafen AG, 88046 Friedrichshafen (DE)
(72) Erfinder: Wang, Pengshuai, 88097 Eriskirch (DE); Trenz, Ivonne, 88046 Friedrichshafen (DE); Pahn, Florian, 88212 Ravensburg (DE)

(56) Entgegenhaltungen:
- CN-A- 105 375 787
- DE-A1- 102017 125 052
- DE-A1- 102017 222 427
- DE-A1- 102018 205 226
- DE-A1- 19 917 286
- DE-C1- 10 048 680
- DE-T5- 112016 000 460
- JP-A- 2004 055 832
- VOGLER BASTIAN ET AL: "Advanced SOI gate driver IC with integrated VCE-monitoring and negative turn-off gate voltage for medium power IGBT modules", 2013 25TH INTERNATIONAL SYMPOSIUM ON POWER SEMICONDUCTOR DEVICES & IC'S (ISPSD), IEEE, 15 June 2014 (2014-06-15), pages 317 - 320, XP032620530, ISSN: 1943-653X, ISBN: 978-1-4673-5134-8, [retrieved on 20140714], DOI: 10.1109/ISPSD.2014.6856040

## Beschreibung

Die Erfindung betrifft ein Leistungsmodul für einen Inverter eines elektrischen Antriebs eines Elektrofahrzeugs oder eines Hybridfahrzeugs sowie einen entsprechenden Inverter.

Im Stand der Technik sind reine Elektrofahrzeuge sowie Hybridfahrzeuge bekannt, welche ausschließlich bzw. unterstützend von einer oder mehreren elektrischen Maschinen als Antriebsaggregate angetrieben werden. Um die elektrischen Maschinen solcher Elektrofahrzeuge bzw. Hybridfahrzeuge mit elektrischer Energie zu versorgen, umfassen die Elektrofahrzeuge und Hybridfahrzeuge elektrische Energiespeicher, insbesondere wiederaufladbare elektrische Batterien. Diese Batterien sind dabei als Gleichspannungsquellen ausgebildet, die elektrischen Maschinen benötigen in der Regel jedoch eine Wechselspannung. Daher wird zwischen einer Batterie und einer elektrischen Maschine eines Elektrofahrzeugs oder eines Hybridfahrzeugs üblicherweise eine Leistungselektronik mit einem sog. Inverter geschaltet.

Derartige Inverter umfassen üblicherweise Halbleiterschaltelemente, die typischerweise aus Transistoren gebildet sind. Dabei ist es bekannt, die Halbleiterschaltelemente in unterschiedlichen Integrationsgraden bereitzustellen, nämlich entweder als diskrete Einzelschalter mit einem geringen Integrationsgrad, jedoch hoher Skalierbarkeit, als Leistungsmodule mit einem hohen Integrationsgrad, jedoch geringer Skalierbarkeit, sowie als Halbbrücken, die hinsichtlich Integrationsgrad und Skalierbarkeit zwischen Einzelschaltern und Halbbrücken rangieren. Jede Halbbrücke umfasst eine Highside-Schaltposition (nachfolgend: "Highside") mit einem höheren elektrischen Potential und eine Lowside-Schaltposition (nachfolgend: "Lowside") mit einem niedrigeren elektrischen Potential. Die Highside und die Lowside können jeweils einen oder mehrere Einzelschalter umfassen, die parallelgeschaltet sind.

Aus der Druckschrift DE 11 2016 000 460 T5 ist ein Leistungsumsetzer für ein Hybridfahrzeug bzw. ein reines Elektrofahrzeug bekannt, der ein Leistungshalbleitermodul, einen Kondensator und Gleichstromsammelschienen aufweist. Die Gleichstromsammelschienen besitzen Anschlüsse, für eine Verbindung mit dem Leistungshalbleitermodul und dem Kondensator, wobei die Gleichstromsammelschienen einen Öffnungsabschnitt zum Einsetzen des Leistungshalbleitermoduls aufweisen. Aus dem Dokument JP 2004 055 832 A sind Stromsammelschienen bekannt, die durch Laminieren von Hochspannung-Sammelschienenelektroden, Niederspannung-Sammelschienenelektroden und Isolierschichten gebildet sind.

In der DE 10 2006 050 291 A1 wird eine elektronische Baugruppe offenbart, die einen Halbleiterleistungsschalter und eine Halbleiterdiode umfasst. Dabei umfasst eine untere Seite des Halbleiterleistungsschalters einen auf ein Chip-Feld eines Trägerstreifens montierten Ausgangskontakt. Zudem umfasst eine obere Seite des Halbleiterleistungsschalters einen Steuerungskontakt und einen Eingangskontakt. Ein Anodenkontakt der Halbleiterdiode ist auf dem Eingangskontakt des Halbleiterleistungsschalters angeordnet und elektrisch mit diesem verbunden. Ein Kathodenkontakt der Diode wird elektrisch mit dem Ausgangskontakt des Leistungshalbleiterschalters verbunden.

Die DE 10 2006 008 632 A1 offenbart ein Leistungshalbleiterbauteil, das einen Flachleiterrahmen, mindestens ein vertikales Leistungshalbleiterbauelement und mindestens ein weiteres elektronisches Bauteil umfasst. Das vertikale Leistungshalbleiterbauelement weist eine erste Seite und eine zweite Seite auf. Mindestens eine erste Kontaktfläche und mindestens eine Steuerungskontaktfläche sind auf der ersten Seite angeordnet. Mindestens eine zweite Kontaktfläche ist auf der zweiten Seite angeordnet. Das mindestens eine weitere elektronische Bauteil ist auf der zweiten Kontaktfläche des vertikalen Leistungshalbleiterbauelements angeordnet.

Aus der DE 10 2015 012 915 A1 ist ein Halbleitermodul mit mindestens zwei Halbleiterelementen bekannt, die jeweils auf einer ersten Seite mindestens eine erste Elektrode und auf einer zweiten Seite mindestens eine zweite Elektrode aufweisen. Das erste Halbleiterelement ist über dem zweiten Halbleiterelement angeordnet. Zwischen dem ersten Halbleiterelement und dem zweiten Halbleiterelement ist eine elektrisch leitende Verbindung angeordnet. Die mindestens eine zweite Elektrode des ersten Halbleiterelements ist mit der elektrisch leitenden Verbindung mechanisch und elektrisch verbunden. Die mindestens eine erste Elektrode des zweiten Halbleiterelements ist mit der elektrisch leitenden Verbindung mechanisch und elektrisch verbunden.

Aus der noch unveröffentlichten DE 10 2019 220 010.9 ist ein Leistungsmodul bekannt, bei dem die Signalanschlüsse und die Leistungsanschlüsse alle an einer gemeinsamen Seite des Substrats angeordnet sind und von einer Vergussmasse umgeben sind. Die Leistungsanschlüsse und die Signalanschlüsse sind allesamt von der gemeinsamen Seite des Substrats aus zugänglich, derart, dass sich die Leistungsanschlüsse und die Signalanschlüsse von der gemeinsamen Seite des Substrats aus gesehen durch die Vergussmasse hindurch erstrecken und aus ihrer Durchtrittsrichtung durch die Vergussmasse gesehen innerhalb einer von dem Substrat aufgespannten Grundfläche angeordnet sind.

Aus der noch unveröffentlichten DE 10 2020 205 420.7 ist ein Leistungsmodul bekannt, bei dem die Leistungsanschlüsse und die Signalanschlüsse alle in einem Flachleiterrahmen ausgeformt sind. Enden der Leistungsanschlüsse und der Signalanschlüsse erstrecken sich seitlich aus der Vergussmasse und weisen jeweils eine rechtwinklige Biegung senkrecht zu einer Fläche, entlang derer sich der Flachleiterrahmen erstreckt.

Zwecks Kontaktierung der Leistungsanschlüsse von außen werden Stromschienen ("Busbars") verwendet. Eine Plus-Stromschiene dient zur Kontaktierung des DC-Plus-Leistungsanschlusses und ist an diesen angebunden. Eine Minus-Stromschiene dient zur Kontaktierung des DC-Minus-Leistungsanschlusses und ist an diesen angebunden. Eine AC-Stromschiene dient zur Kontaktierung des AC-Leistungsanschlusses und ist an diesen angebunden. Dadurch, dass bei Hochvolt-Anwendungen hohe Spannungsdifferenzen zwischen den an den jeweiligen Leistungsanschlüssen anliegenden Potentialen herrschen, die bis zu mehrere hundert Volt betragen, müssen die Leistungsanschlüsse und damit einhergehend auch deren zugehörigen Stromschienen voneinander elektrisch isoliert sein. Hierzu müssen die Kriech- und Luftstrecken zwischen den einzelnen Leistungsanschlüssen sowie zwischen den einzelnen Stromschienen einen Mindestabstand einhalten.

Um diese Anforderung zu erfüllen wird bei den bisher bekannten Halbbrücken und Invertern der Abstand zwischen den Leistungsanschlüssen bzw. zwischen den Stromschienen relativ groß gewählt. Wenn der Abstand groß genug ist, werden die geforderten Luft- und Kriechstrecken eingehalten und die Anforderungen erfüllt. Geringer Abstand zwischen den Stromschienen führt zu einem niederinduktiven Busbar-Design, bei dem die Halbbrücken bzw. der Inverter einen größeren Bauraum benötigen, was dem Ziel in der gegenwärtigen Automobilindustrie, die in einem Fahrzeug verbauten elektronischen Bauteile immer kompakter zu gestalten, entgegensteht.

Es ist eine Aufgabe der Erfindung, eine Halbbrücke für einen elektrischen Antrieb eines Elektro- oder Hybridfahrzeugs bereitzustellen, bei der die vorstehend genannten Nachteile zumindest teilweise überwunden sind.

Diese Aufgabe wird erfindungsgemäß durch die Halbbrücke, das Leistungsmodul und den Inverter gemäß den unabhängigen Patentansprüchen gelöst. Vorteilhafte Ausgestaltungen und Weiterbildungen der Erfindung gehen aus den abhängigen Patentansprüchen hervor.

Die Erfindung betrifft eine Halbbrücke für einen elektrischen Antrieb eines Elektrofahrzeugs oder eines Hybridfahrzeugs.

Das Substrat kann beispielsweise als DBC- (Direct Bonded Copper) Substrat, als DPC- (Direct Plated Copper) Substrat, als AMB- (Active Metal Brazing) Substrat oder als IM- (Insulated Metal) Substrat ausgebildet sein. Auf dem Substrat sind einerseits die Halbleiterschaltelemente angeordnet, insbesondere Transistoren und Dioden, und andererseits die zugehörigen Leistungsanschlüsse und Signalanschlüsse. Das Substrat ist bevorzugt rechteckig ausgebildet, insbesondere als flaches, scheibenartiges Rechteck, mit je zwei gegenüberliegenden Seitenkanten. Ggf. kann das Substrat auch quadratisch ausgebildet sein.

Die Halbleiterschaltelemente bilden in der Halbbrücke eine Highside und eine Lowside. Die Highside umfasst ein oder mehrere zueinander parallelgeschaltete Halbleiterschaltelemente, und ermöglicht den Stromfluss zwischen dem AC-Leistungsanschluss und dem DC-Plus-Leistungsanschluss. Die Lowside umfasst ein oder mehrere zueinander parallelgeschaltete Halbleiterschaltelemente und ermöglicht den Stromfluss zwischen dem AC-Leistungsanschluss und dem DC-Minus-Leistungsanschluss. Die Highside und die Lowside sind zueinander reihengeschaltet.

Die Leistungsanschlüsse sind ihrerseits mit in den Halbleiterschaltelementen integrierten Leistungskontakten, bspw. Source-Elektroden und Drain-Elektroden, oder mit einer Erdmasse elektrisch verbunden, so dass elektrische Leistung von einem Leistungsanschluss durch ein Halbleiterschaltelement zu einem weiteren Leistungsanschluss übertragen werden kann. Über die Leistungsanschlüsse wird dabei die elektrische Versorgung des Elektromotors zum Antrieb des Elektrofahrzeugs oder des Hybridfahrzeugs gewährleistet.

Die Signalanschlüsse dienen zum elektrischen Schalten der Halbleiterschaltelemente und sind entsprechend mit in den Halbleiterschaltelementen integrierten Signalkontakten der Halbleiterschaltelemente elektrisch verbunden. Je nach Ausbildung der Halbleiterschaltelemente kann dann durch eine Bestromung oder eine Spannungsbeaufschlagung des Signalkontakts das Halbleiterschaltelement stromleitend bzw. stromsperrend geschaltet werden. Vorzugsweise werden auf diese Weise die Halbleiterschaltelemente gemäß einer Pulsbreitenmodulation (Engl.: Pulse-Width-Modulation, PWM) geschaltet, um einen sinusförmigen zeitlichen Verlauf der Phasenströme zu ermöglichen.

Die Halbleiterschaltelemente, die Leistungsanschlüsse und die Signalanschlüsse der erfindungsgemäßen Halbbrücke sind vorzugsweise auf einer ersten Fläche des Substrats angeordnet. Die Leistungsanschlüsse und die Signalanschlüsse können dort auf einfache Weise von externen Bauteilen, insbesondere Stromschienen (etwa Busbars) kontaktiert werden. Bei der ersten Fläche handelt es sich bevorzugt um eine der zwei einander gegenüberliegenden, vergleichsweise größten Flächen des schichtförmigen Substrats. Die erste Fläche definiert eine Hauptebene des Substrats.

Das Substrat ist vorzugsweise mit einer Vergussmasse per Spritzgussverfahren vergossen. Die Leistungsanschlüsse und/oder die Signalanschlüsse weisen vorzugsweise externe Abschnitte auf, die sich aus einer zur ersten Fläche orthogonalen zweiten Fläche aus der Vergussmasse heraus nach außen erstrecken. Die zweite Fläche ist dabei eine "Seitenfläche" des vergossenen, schichtförmigen Substrats, die in der Regel deutlich kleiner ist als die erste Fläche. Vorzugsweise weisen die externen Abschnitte jeweils ein Ende auf, welches sich senkrecht zur ersten Fläche erstreckt. Dies ermöglicht eine einfache elektrische Kontaktierung der Leistungsanschlüsse bzw. der Signalanschlüsse von außerhalb der Halbbrücke.

Zum DC-Plus-Leistungsanschluss und zum DC-Minus-Leistungsanschluss ist jeweils eine Stromschiene zur externen Kontaktierung vorgesehen, die an den jeweiligen Leistungsanschluss angebunden ist. Die Stromschiene des DC-Plus-Leistungsanschlusses und des DC-Minus-Leistungsanschlusses erstreckt sich entlang einer Richtung parallel zur Hauptebene des Substrats zwischen einer Leiterplatte und dem Substrat. Die Stromschiene weist eine Oberseite, die der Leiterplatte zugewandt ist, und eine Unterseite, die dem Substrat zugewandt ist, auf.

Erfindungsgemäß ist die Stromschiene des DC-Plus-Leistungsanschlusses und/oder des DC-Minus-Leistungsanschlusses mit einer stromisolierenden Beschichtung zumindest teilweise bedeckt. Die stromisolierende Beschichtung kann ein vorgefertigtes Bauteil, etwa aus Kunststoff, aufweisen, welches eine Ausnehmung zur Aufnahme der Stromschiene(n) aufweist. Alternativ kann die stromisolierende Beschichtung ein Spritzgussteil sein, welches per Spritzgussverfahren auf den DC-Plus-Leistungsanschluss und/oder des DC-Minus-Leistungsanschluss aufgespritzt ist.

Dadurch, dass die Stromschiene zumindest eines der beiden DC-Leistungsanschlüsse mit der stromisolierenden Beschichtung zumindest teilweise bedeckt ist, ist die Kriechstrecke zwischen den Stromschienen der beiden DC-Leistungsanschlüsse verlängert. Auf diese Weise ist eine sichere galvanische Trennung zwischen den Stromschienen der beiden DC-Leistungsanschlüsse gewährleistet. Gleichzeitig kann der Abstand zwischen den beiden Stromschienen der DC-Leistungsanschlüsse reduziert werden, was zu einem niederinduktiven Inverter führt.

Die Erfindung betrifft weiterhin ein Leistungsmodul mit zumindest drei erfindungsgemäßen Halbbrücken, wobei jede der Halbbrücken vorzugsweise einer von zumindest drei Stromphasen eines Wechselstroms, der mittels des Leistungsmoduls basierend auf einem eingespeisten Gleichstrom erzeugt ist, zugeordnet ist. Ferner betrifft die Erfindung einen Inverter für einen elektrischen Antrieb eines Elektrofahrzeugs oder eines Hybridfahrzeugs mit einem solchen Leistungsmodul. Daraus ergeben sich die bereits im Zusammenhang mit der erfindungsgemäßen Halbbrücke beschriebenen Vorteile auch für das erfindungsgemäße Leistungsmodul und den erfindungsgemäßen Inverter.

Gemäß einer Ausführungsform ist die Stromschiene oberseitig und/oder unterseitig mit der stromisolierenden Beschichtung bedeckt. Die Oberseite der Stromschiene ist der Leiterplatte zugewandt. Die Unterseite der Stromschiene ist dem Substrat bzw. der Vergussmasse zugewandt. Eine nur einseitige Bedeckung der Stromschiene mit der stromisolierenden Beschichtung hat den Vorteil der Materialeinsparung. Eine doppelseitige Bedeckung der Stromschiene mit der stromisolierenden Beschichtung hat den Vorteil der weiteren Verlängerung der Kriechstrecke zwischen den Stromschienen der beiden DC-Leistungsanschlüsse.

Gemäß einer weiteren Ausführungsform weist die mit der stromisolierenden Beschichtung bedeckte Stromschiene entlang der Richtung parallel zur Hauptebene des Substrats zwei zueinander einen Winkel einschließende Flächenabschnitte auf. Entlang der parallel zur Hauptebene des Substrats verlaufenden Richtung weist die bedeckte Stromschiene einen ersten Flächenabschnitt auf. Am Ende des ersten Flächenabschnittes geht der erste Flächenabschnitt in einen zweiten Flächenabschnitt über, der mit dem ersten Flächenabschnitt den Winkel einschließt. Der Winkel ist vorzugsweise größer als 90 Grad und kleiner als 180 Grad. Der zweite Flächenabschnitt kann durch eine in der stromisolierenden Beschichtung ausgebildete Rippe bewerkstelligt sein. Diese Maßnahme verlängert zusätzlich die Kriechstrecke zwischen den Stromschienen der beiden DC-Leistungsanschlüsse.

Gemäß einer weiteren Ausführungsform ist nur eine der beiden Stromschienen mit der stromisolierenden Beschichtung bedeckt, wobei die andere der beiden Stromschienen auf einer vom Substrat abgewandten Seite mit einer isolierenden Dünnschichtfolie beschichtet ist. Die isolierende Dünnschichtfolie kann beispielsweise aus einem Zwischenkreiskondensator herausgeführt sein. Die isolierende Dünnschichtfolie ist eine flexible Folie, die sich besonders einfach an die Form der Stromschiene anpassen lässt, die nicht mit der stromisolierenden Beschichtung bedeckt, insbesondere umspritzt, ist. Hierdurch ist eine verbesserte galvanische Trennung zwischen den beiden Stromschienen gewährleistet.

Gemäß einer weiteren Ausführungsform wird an der stromisolierenden Beschichtung der DC Plus Stromschiene oberseitig die Leiterplatte fixiert und/oder die stromisolierende Beschichtung der DC Plus Stromschiene unterseitig am Invertergehäuse fixiert. Auf diese Weise ist eine besonders stabile Fixierung der Leiterplatte bewerkstelligt. Eine sichere Anbindung zwischen der Stromschiene und dem zugehörigen DC-Leistungsanschluss ist daher gewährleistet. Zur Fixierung wird eine Schraubverbindung und ein heißverstemmter Kunststoffdom vorgesehen. Ein heißverstemmter Kunststoffdom ist ein Kunststoffdom, welcher sich aus der stromisolierenden Beschichtung heraus durch eine Öffnung der Leiterplatte erstreckt, und mittels Heißverstemmens zum Schmelzen gebracht wird und nach anschließendem Abkühlen sich verhärtet und somit eine Fixierung bewerkstelligt.

Nachfolgend wird die Erfindung anhand von in den Figuren dargestellten Ausführungsformen beispielhaft erläutert.

Es zeigen:
- Fig. 1: eine schematische seitliche Schnittansicht eines Inverters umfassend eine erfindungsgemäße Halbbrücke gemäß einer konventionellen Ausführungsform:
- Fig. 2: eine schematische perspektivische Schnittansicht des Inverters aus Fig. 1;
- Fig. 3: eine schematische seitliche Schnittansicht eines Inverters umfassend eine erfindungsgemäße Halbbrücke gemäß einer Ausführungsform; und
- Fig. 4: eine schematische perspektivische Schnittansicht des Inverters aus Fig. 3.

Gleiche Gegenstände, Funktionseinheiten und vergleichbare Komponenten sind figurenübergreifend mit den gleichen Bezugszeichen bezeichnet. Diese Gegenstände, Funktionseinheiten und vergleichbaren Komponenten sind hinsichtlich ihrer technischen Merkmale identisch ausgeführt, sofern sich aus der Beschreibung nicht explizit oder implizit etwas anderes ergibt.

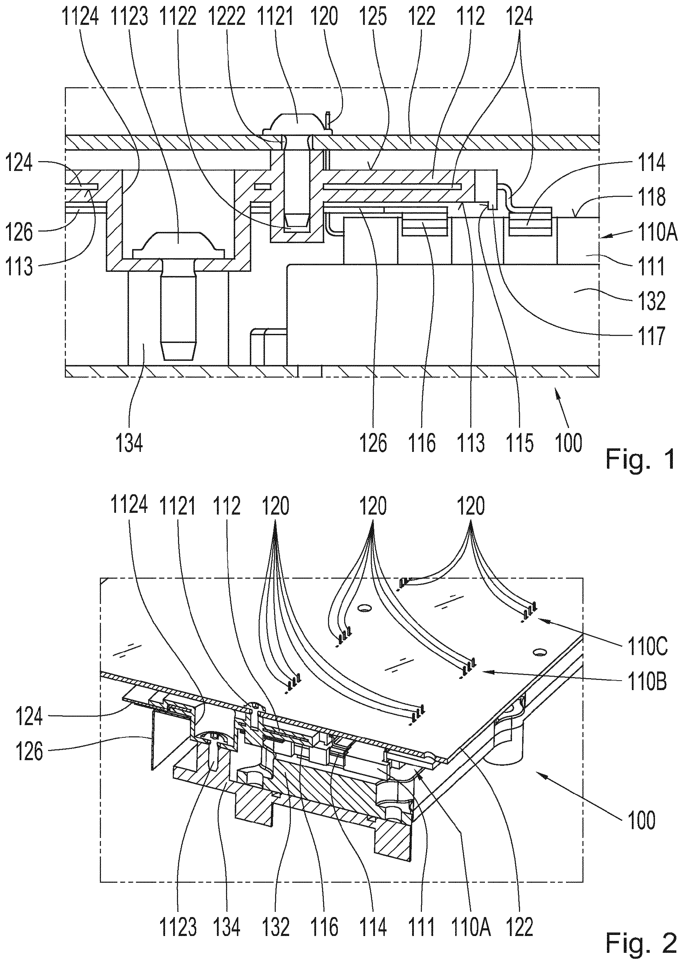

Fig. 1 und 2 zeigen eine schematische Darstellung eines Inverters 100 gemäß einer konventionellen Ausführungsform.

Fig. 1 zeigt schematisch eine seitliche Schnittansicht des Inverters 100. Der Inverter 100 umfasst mehrere Halbbrücken 110A, 110B, 110C, die in Fig. 2 schematisch in einer perspektivischen Schnittansicht dargestellt sind. Jede Halbbrücke 110A, 110B, 110C weist mehrere Halbleiterschaltelemente auf, die hier nicht gezeigt sind. Die Halbleiterschaltelemente bilden eine Highside und eine Lowside, die jeweils ein oder mehrere parallelgeschaltete Halbleiterschaltelemente umfassen. Jede der Halbbrücken 110A, 110B, 110C ist einer Stromphase zugeordnet. Jede Halbbrücke 110A, 110B, 110C umfasst ein Substrat (nicht gezeigt), auf dem die Halbleiterschaltelemente aufgebracht sind. Das Substrat ist vorzugsweise ein Direct-Bonded-Copper (DBC)-Substrat mit einer ersten und einer zweiten Metalllage sowie einer dazwischen angeordneten Isolierlage. Die Halbleiterschaltelemente der jeweiligen Halbbrücke 110A, 110B, 110C sind auf der ersten Metalllage angeordnet. An der zweiten Metalllage ist ein Kühlkörper 132 angebunden.

Zum Schutz vor äußeren Umwelteinflüssen sind die Halbleiterschaltelemente und das Substrat mit einer Vergussmasse 111 (z.B. Kunststoff) vergossen. Das Substrat definiert eine Hauptebene parallel zu den Metall- und Isolierlagen, die senkrecht zur Zeichenebene in Fig. 1 verläuft. Ein DC-Plus-Leistungsanschluss 114 und ein DC-Minus-Leistungsanschluss 116 sowie mehrere Signalanschlüsse 120 treten seitlich aus der Vergussmasse 111 heraus und können von oben kontaktiert werden. Die DC-Leistungsanschlüsse 114, 116 dienen zum Einspeisen eines Eingangsstroms, der ein Gleichstrom ist und mittels Ansteuerung der Halbleiterschaltelemente in einen mehrphasigen Wechselstrom umgewandelt werden kann. Zur Ansteuerung der Halbleiterschaltelemente dienen die Signalanschlüsse 120 in Zusammenwirkung mit einer Ansteuerleiterplatte 122, die über Leiterbahnen und elektronische Bauteil verfügt, um Steuersignale zu erzeugen und über die Signalanschlüsse an die Gate-Elektroden der Halbleiterschaltelemente zu senden.

Der DC-Plus-Leistungsanschluss 114 ist mittels einer DC-Plus-Stromschiene 124 nach außen kontaktiert. Gleichzeitig ist der DC-Minus-Leistungsanschluss 116 mittels einer DC-Minus-Stromschiene 126 nach außen kontaktiert. Sowohl die DC-Plus-Stromschiene 124 als auch die DC-Minus-Stromschiene 126 sind plattenförmig ausgeformt und erstrecken sich parallel zur Hauptebene des Substrats zwischen der Leiterplatte 122 und der Vergussmasse 111. Wie in Fig. 1 und Fig. 2 gezeigt, ist die DC-Plus-Stromschiene 124 an ihrer Oberseite 125 und Unterseite 123 mit einer stromisolierenden Beschichtung 112 bedeckt, die hier vorzugsweise als Umspritzung mittels eines Spritzgussverfahrens bereitgestellt ist. Vorzugsweise wird die DC-Plus-Stromschiene 124 zuerst mit der stromisolierenden Beschichtung umspritzt und nach dem Umspritzen erst mit dem DC-Plus-Leistungsanschluss 114 verbunden.

Die Beschichtung bzw. Umspritzung 112 weist, hier beispielhaft an einem Ende, eine Rippe 117 auf, die einen ersten Flächenabschnitt 113 und einen zweiten Flächenabschnitt 115 umfasst, wobei beide Flächenabschnitte 113, 115 einen Winkel einschließen. Die Rippe 117 dient dazu, die Luft- und Kriechstrecken zu verlängern. Die DC-Minus-Stromschiene 126 ist in dieser Ausführungsform nicht mit einer stromisolierenden Beschichtung bedeckt, sondern unter der umspritzten DC-Plus-Stromschiene 124 montiert. In der DC-Minus-Stromschiene 126 sind Materialaussparungen vorgesehen, beispielsweise als Anschraubpunkte der umspritzten DC-Plus-Stromschiene 124.

Eine Bedeckung mittels einer stromisolierenden Beschichtung bzw. Umspritzung 112 vergrößert die Kriechstrecke zwischen den beiden DC-Stromschienen 124, 126 und erhöht die Sicherheit des Inverters 100 hinsichtlich galvanischer Trennung zwischen dem DC-Plus-Potential und dem DC-Minus-Potential, was bei Hochvoltanwendungen wichtig ist. Auf diese Weise kann ein Mindestmaß an Luft- und Kriechstrecken eingehalten werden.

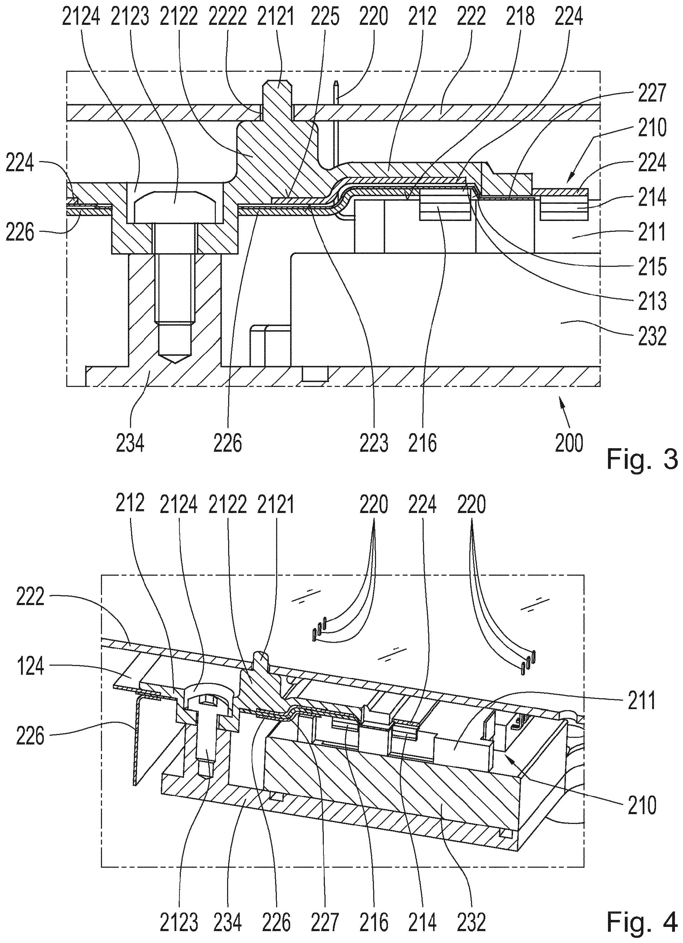

Zur Fixierung der Beschichtung bzw. Umspritzung 112 oberseitig an der Leiterplatte 122 ist eine erste Schraubverbindung vorgesehen, bei der eine Schraube 1121 durch ein Loch 1222 in der Leiterplatte 122 in eine in der Beschichtung bzw. Umspritzung 112 ausgebildete Öffnung 1122 hineingeführt ist. Alternativ kann ein heißverstemmter Kunststoffdom verwendet werden, wie in Fig. 3 näher beschrieben ist. Dies ermöglicht eine hohe mechanische Stabilität des Gesamtaufbaus aus der Beschichtung bzw. Umspritzung 112, der Vergussmasse 111 sowie der Leiterplatte 122, und sichert die Anbindung zwischen den Leistungsanschlüssen 114, 116 und den Stromschienen 124, 126. Zusätzlich treten die Signalanschlüsse 120 durch die Beschichtung bzw. Umspritzung 112 und weiter oben auch durch die Leiterplatte 122 hindurch, wie in Fig. 2 näher gezeigt. Zur Fixierung der Beschichtung bzw. Umspritzung 112 unterseitig an einem Invertergehäuse 134 ist eine zweite Schraubverbindung vorgesehen, bei der eine Schraube 1123 durch eine in der Beschichtung bzw. Umspritzung 112 ausgebildete Ausnehmung 1124 in eine im Invertergehäuse 134 angeordnete Öffnung hineingeführt ist.

Die umspritzte Stromschiene bestehend aus der DC-Plus-Stromschiene 124 und der Umspritzung 112 wird über den ausgeformten Dom bzw. Anschraubpunkt 1124 mittels der Schraube 1123 in das Invertergehäuse 134 verschraubt. Die Leiterplatte 122 wird durch das Loch (bzw. Bohrung) 1222 mittels der Schraube 1121 in den ausgebildeten Schraubdom 1122 der Kunststoffumspritzung 112 verschraubt. Durch die Verschraubung 1123 der umspritzten Stromschiene in das steife Invertergehäuse 134 und die Anschraubung der Leiterplatte 122 in die umspritzte Stromschiene mittels der Schraube 1121 wird ein Aufbau mit einer hohen mechanischen Stabilität/Steifigkeit erzeugt.

Die Anschraubpunkte umfassend die Schrauben 1121 und 1123 sind vorzugsweise zueinander benachbart angeordnet. Hierdurch lässt sich die Leiterplatte 122 über die umspritzte Stromschiene bestmöglich an das steife Invertergehäuse 134 anbinden. Gleichzeitig kann die Vibrationsbelastungen auf die Leiterplatte 122 reduziert werden können.

Durch die Verschraubung mittels der Schraube 1123 wird die umspritzte Stromschiene in das Invertergehäuse 134 zusätzlich mechanisch stabilisiert und die mechanische Belastung, wie zum Beispiel durch Vibration auf die Verbindung zwischen dem positiven Leistungsanschlüssen 114 einerseits und der DC-Plus-Stromschiene 124 andererseits, reduziert. Die Signalanschlüsse 120 werden durch die Umspritzung 112 durchgesteckt und mit der Leiterplatte 122 kontaktiert.

Fig. 3 und 4 zeigen eine schematische Darstellung eines Inverters 200 gemäß einer erfindungsgemäßen Ausführungsform.

Fig. 3 zeigt schematisch eine seitliche Schnittansicht des Inverters 200. Fig. 4 zeigt den Inverter 200 in einer perspektivischen Schnittansicht. Der Inverter 200 umfasst mehrere Halbbrücken 210, wobei hier nur eine Halbbrücke 210 gezeigt ist. Jede Halbbrücke 210 weist mehrere Halbleiterschaltelemente auf, die hier nicht gezeigt sind. Die Halbleiterschaltelemente bilden eine Highside und eine Lowside, die jeweils ein oder mehrere parallelgeschaltete Halbleiterschaltelemente umfassen. Jede der Halbbrücken 210 ist einer Stromphase zugeordnet. Jede Halbbrücke 210 umfasst ein Substrat (nicht gezeigt), auf dem die Halbleiterschaltelemente aufgebracht sind. Das Substrat ist vorzugsweise ein Direct-Bonded-Copper (DBC)-Substrat mit einer ersten und einer zweiten Metalllage sowie einer dazwischen angeordneten Isolierlage. Die Halbleiterschaltelemente der jeweiligen Halbbrücke 210 sind auf der ersten Metalllage angeordnet. An der zweiten Metalllage ist ein Kühlkörper 232 angebunden. Analog zum Inverter 100 aus Fig. 1-2 sind auch hier die Halbleiterschaltelemente und das Substrat zum Schutz vor äußeren Umwelteinflüssen mit einer Vergussmasse 211 (z.B. Kunststoff) vergossen. Das Substrat definiert eine Hauptebene parallel zu den Metall- und Isolierlagen, die senkrecht zur Zeichenebene in Fig. 3 verläuft. Ein DC-Plus-Leistungsanschluss 214 und ein DC-Minus-Leistungsanschluss 216 sowie mehrere Signalanschlüsse 220 treten seitlich aus der Vergussmasse 211 heraus und können von oben kontaktiert werden. Die DC-Leistungsanschlüsse 214, 216 dienen zum Einspeisen eines Eingangsstroms, der ein Gleichstrom ist und mittels Ansteuerung der Halbleiterschaltelemente in einen mehrphasigen Wechselstrom umgewandelt werden kann. Zur Ansteuerung der Halbleiterschaltelemente dienen die Signalanschlüsse 220 in Zusammenwirkung mit einer Ansteuerleiterplatte 222, die über Leiterbahnen und elektronische Bauteil verfügt, um Steuersignale zu erzeugen und über die Signalanschlüsse an die Gate-Elektroden der Halbleiterschaltelemente zu senden.

Der DC-Plus-Leistungsanschluss 214 ist mittels einer DC-Plus-Stromschiene 224 nach außen kontaktiert. Gleichzeitig ist der DC-Minus-Leistungsanschluss 216 mittels einer DC-Minus-Stromschiene 226 nach außen kontaktiert. Sowohl die DC-Plus-Stromschiene 224 als auch die DC-Minus-Stromschiene 226 sind plattenförmig ausgeformt und erstrecken sich parallel zur Hauptebene des Substrats zwischen der Leiterplatte 222 und der Vergussmasse 211. Wie in Fig. 3 und Fig. 4 gezeigt, ist die DC-Plus-Stromschiene 224 an ihrer Oberseite 225 mit einer stromisolierenden Beschichtung 212 bedeckt, die hier vorzugsweise als Umspritzung mittels eines Spritzgussverfahrens bereitgestellt ist. An ihrer Unterseite 223 ist die DC-Plus-Stromschiene 224 jedoch nicht beschichtet. Vorzugsweise wird die DC-Plus-Stromschiene 224 zuerst mit der stromisolierenden Beschichtung umspritzt und nach dem Umspritzen erst mit dem DC-Plus-Leistungsanschluss 214 verbunden.

Die DC-Plus-Stromschiene 224 weist eine Biegung auf. Entsprechend weist die Beschichtung bzw. Umspritzung 212 an einem Ende einen Winkel zwischen einem ersten Flächenabschnitt 213 und einem zweiten Flächenabschnitt 215 umfasst. Im Bereich des Winkels ist die DC-Plus-Stromschiene 224 nur lokal ausgespart. Die DC-Minus-Stromschiene 226 ist auf ihrer der DC-Plus-Stromschiene 224 zugewandten Seite mit einer stromisolierenden Dünnschichtfolie 227 bedeckt und erstreckt sich durch die Beschichtung bzw. Umspritzung 212 der DC-Plus-Stromschiene 224 hindurch. Die stromisolierende Dünnschichtfolie 227 ist lokal ausgespart, um, wie hier beispielhaft gezeigt, einen Schraubdom (siehe Ausnehmung 2124) für die Verschraubung mittels einer Schraube 2123 anzuordnen.

Eine Bedeckung mittels einer stromisolierenden Beschichtung bzw. Umspritzung 212 vergrößert die Kriechstrecke zwischen den beiden DC-Stromschienen 224, 226 und erhöht die Sicherheit des Inverters 200 hinsichtlich galvanischer Trennung zwischen dem DC-Plus-Potential und dem DC-Minus-Potential, was bei Hochvoltanwendungen wichtig ist. Der Einsatz der stromisolierenden Dünnschichtfolie 227 gewährleistet die Potentialtrennung. Die DC-Plus-Stromschiene 224 ist nur oberseitig beschichtet bzw. umspritzt, sodass zwischen den beiden DC-Stromschienen 224 und 226 keine Umspritzung existiert. Durch die Umspritzung 212 erfolgt die Isolierung der DC-Plus-Stromschiene 224 zur Leiterplatte 222. Die DC-Plus-Stromschiene 224 weist unterseitig vorzugsweise eine Kupferoberfläche auf. Die Isolierung zwischen der DC-Plus-Stromschiene 224 und der DC-Minus-Stromschiene 226 erfolgt über die stromisolierende Dünnschichtfolie 227. Auf diese Weise kann ein Mindestmaß an Luft- und Kriechstrecken eingehalten werden.

Zur Fixierung der Beschichtung bzw. Umspritzung 212 oberseitig an der Leiterplatte 222 ist ein heißverstemmter Kunststoffdom 2121 vorgesehen, wie in Fig. 3 näher gezeigt ist. Der Kunststoffdom 2121 tritt durch ein in der Leiterplatte 222 ausgebildetes Loch 2222 hindurch. Mittels eines Heißverstemmverfahrens wird der Kunststoffdom 2121 zum Schmelzen gebracht, sodass das Kunststoffmaterial das Loch 2222 vollständig schließt. Ein Grundkörper 2122 des Kunststoffdoms 2121 trägt die Leiterplatte 222 von unten. Dies ermöglicht eine hohe mechanische Stabilität des Gesamtaufbaus aus der Beschichtung bzw. Umspritzung 212, der Vergussmasse 211 sowie der Leiterplatte 222, und sichert die Anbindung zwischen den Leistngsanschlüssen 214, 216 und den Stromschienen 224, 226. Zusätzlich treten die Signalanschlüsse 120 durch die Beschichtung bzw. Umspritzung 112 und weiter oben auch durch die Leiterplatte 122 hindurch, wie in Fig. 4 näher gezeigt. Zur Fixierung der Beschichtung bzw. Umspritzung 212 unterseitig an einem Invertergehäuse 234 ist analog zur Ausführungsform aus Fig. 1-2 eine Schraubverbindung vorgesehen, bei der eine Schraube 2123 durch eine in der Beschichtung bzw. Umspritzung 212 ausgebildete Ausnehmung 2124 in eine im Invertergehäuse 234 angeordnete Öffnung hineingeführt ist.

Die umspritzte Stromschiene bestehend aus der DC-Plus-Stromschiene 224 und der Umspritzung 212 wird über den ausgeformten Dom (siehe Ausnehmung 2124), der als Anschraubpunkt dient, mittels der Schraube 2123 in das Invertergehäuse 234 verschraubt. Die Leiterplatte 222 wird durch das Loch (bzw. Bohrung) 2222 mittels des heißverstemmten Doms 2121 an der Umspritzung 212 fixiert. Durch die Verschraubung 2123 der umspritzten Stromschiene in das steife Invertergehäuse 234 und die Fixierung der Leiterplatte 222 an der umspritzten DC-Plus-Stromschiene 224 mittels des heißverstemmten Kunststoffdoms 2121 wird ein Aufbau mit einer hohen mechanischen Stabilität/Steifigkeit bereitgestellt.

Der Anschraubpunkt für die Schraube 2123 und die Fixierungsstelle für den den Kunststoffdom 2121 sind vorzugsweise zueinander benachbart angeordnet. Hierdurch lässt sich die Leiterplatte 222 über die umspritzte DC-Plus-Stromschiene 224 bestmöglich an das steife Invertergehäuse 234 anbinden. Gleichzeitig kann die Vibrationsbelastungen auf die Leiterplatte 222 reduziert werden können.

Durch die Verschraubung mittels der Schraube 2123 wird die umspritzte Stromschiene in das Invertergehäuse 234 zusätzlich mechanisch stabilisiert und die mechanische Belastung, wie zum Beispiel durch Vibration auf die Verbindung zwischen den positiven Leistungsanschlüssen 214 einerseits und der DC-Plus-Stromschiene 224 andererseits, reduziert. Die Signalanschlüsse 220 werden durch die Umspritzung 212 durchgesteckt und mit der Leiterplatte 222 kontaktiert.

### Bezugszeichen

- 100, 200: Inverter
- 110A-C, 210: Halbbrücke
- 111, 211: Vergussmasse
- 112, 212: Beschichtung/Umspritzung
- 1121: Schraube
- 2121: Kunststoffdom
- 1122: Öffnung
- 2122: Grundkörper
- 1123, 2123: Schraube
- 1124, 2124: Ausnehmung
- 113, 213: erster Flächenabschnitt
- 114, 214: DC-Plus-Leistungsanschluss
- 115, 215: zweiter Flächenabschnitt
- 116, 216: DC-Minus-Leistungsanschluss
- 117: Rippe
- 118, 218: Oberseite
- 120, 220: Signalanschlüsse
- 122, 222: Leiterplatte
- 1222, 2222: Loch
- 123, 223: Unterseite
- 124, 224: DC-Plus-Stromschiene
- 125, 225: Oberseite
- 126, 226: DC-Minus-Stromschiene
- 227: Dünnschichtfolie
- 132, 232: Kühlkörper
- 134, 234: Invertergehäuse

## Patentansprüche

1. Halbbrücke (210) für einen elektrischen Antrieb eines Elektrofahrzeugs oder eines Hybridfahrzeugs, die Halbbrücke (110A-C) umfassend ein Substrat, Halbleiterschaltelemente, Leistungsanschlüsse (214, 216) und Signalanschlüsse (220), die Leistungsanschlüsse (214, 216) umfassend einen DC-Plus-Leistungsanschluss (214), einen DC-Minus-Leistungsanschluss (216) und einen AC-Leistungsanschluss,
wobei die Signalanschlüsse (220) derart an die Halbleiterschaltelemente elektrisch angebunden werden, dass die Halbleiterschaltelemente über die Signalanschlüsse (220) schaltbar sind, wobei die Leistungsanschlüsse (214, 216) derart an die Halbleiterschaltelemente elektrisch angebunden werden, dass die Halbleiterschaltelemente eine elektrische Leistungsübertragung zwischen den Leistungsanschlüssen (214, 216) zulassen oder unterbrechen,
wobei zum DC-Plus-Leistungsanschluss (214) und zum DC-Minus-Leistungsanschluss (216) jeweils eine Stromschiene (224, 226) zur externen Kontaktierung vorgesehen ist, die an den jeweiligen Leistungsanschluss (214, 216) angebunden ist, wobei sich die Stromschiene (224, 226) des DC-Plus-Leistungsanschlusses (214) und des DC-Minus-Leistungsanschlusses (216) entlang einer Richtung parallel zu einer Hauptebene des Substrats zwischen einer Leiterplatte (222) und dem Substrat erstreckt, wobei die Stromschiene (224, 226) eine Oberseite (225) und eine Unterseite (223) aufweist,
wobei die Stromschiene (224, 226) des DC-Plus-Leistungsanschlusses (214) und/oder des DC-Minus-Leistungsanschlusses (216) mit einer stromisolierenden Beschichtung (212) zumindest teilweise bedeckt ist, wobei die stromisolierende Beschichtung (212) oberseitig an der Leiterplatte (222) xiert ist und unterseitig an einem Invertergehäuse (234) des elektrischen Antriebs fixiert ist, wobei zur Fixierung der Stromschiene (224, 226) des DC-Plus-Leistungsanschlusses (214) und/oder des DC-Minus-Leistungsanschlusses (216) an dem Invertergehäuse (234) eine Schraubverbindung und zur Verbindung der Leiterplatte (222) an der Stromschiene (224, 226) des DC-Plus-Leistungsanschlusses (214) und/oder des DC-Minus-Leistungsanschlusses (216) ein heißverstemmter Kunststoffdom (2121) vorgesehen ist, wobei der heißverstemmte Kunststoffdom ein Kunststoffdom ist, welcher dazu ausgebildet ist, sich aus der stromisolierenden Beschichtung heraus durch eine Öffnung (2222) der Leiterplatte (222) zu erstrecken.

2. Halbbrücke (210) nach Anspruch 1, wobei die stromisolierende Beschichtung (212) ein vorgefertigtes Bauteil ist, welches eine Ausnehmung zur Aufnahme der Stromschiene (224, 226) des DC-Plus-Leistungsanschlusses (214) und/oder des DC-Minus-Leistungsanschlusses (216) umfasst.

3. Halbbrücke (210) nach Anspruch 1, wobei die stromisolierende Beschichtung (212) ein Spritzgussteil ist, welches mittels eines Spritzgussverfahrens auf die Stromschiene (224, 226) des DC-Plus-Leistungsanschlusses (214) und/oder des DC-Minus-Leistungsanschlusses (216) aufgespritzt ist.

4. Halbbrücke (210) nach einem der vorangehenden Ansprüche, wobei die Stromschiene (124, 224, 126, 226) oberseitig und/oder unterseitig mit der stromisolierenden Beschichtung (112, 212) bedeckt ist.

5. Halbbrücke (210) nach einem der vorangehenden Ansprüche, wobei die mit der stromisolierenden Beschichtung (112, 212) bedeckte Stromschiene (124, 224, 126, 226) entlang der Richtung parallel zur Hauptebene des Substrats zwei zueinander einen Winkel einschließende Flächenabschnitte aufweist.

6. Halbbrücke (210) nach einem der vorangehenden Ansprüche, wobei nur eine der beiden Stromschienen (224, 226) mit der stromisolierenden Beschichtung (212) bedeckt ist, wobei die andere der beiden Stromschienen (224, 226) auf einer vom Substrat abgewandten Seite mit einer isolierenden Dünnschichtfolie (227) beschichtet ist.

7. Leistungsmodul für einen Inverter, umfassend mindestens drei Halbbrücken (210) nach einem der vorangehenden Ansprüche.

8. Inverter für einen elektrischen Antrieb eines Elektrofahrzeugs oder eines Hybridfahrzeugs, umfassend ein Leistungsmodul nach Anspruch 7.

## Claims

1. Half-bridge (210) for an electric drive of an electric vehicle or a hybrid vehicle, the half-bridge (110A-C) comprising a substrate, semiconductor switching elements, power connections (214, 216) and signal connections (220), the power connections (214, 216) comprising a positive DC power connection (214), a negative DC power connection (216) and an AC power connection,
wherein the signal connections (220) are electrically connected to the semiconductor switching elements in such a way that the semiconductor switching elements are able to be switched by means of the signal connections (220), wherein the power connections (214, 216) are electrically connected to the semiconductor switching elements in such a way that the semiconductor switching elements permit or interrupt an electrical power transmission between the power connections (214, 216),
wherein a respective busbar (224, 226) is provided for the positive DC power connection (214) and for the negative DC power connection (216) for the purpose of external contact-connection, said busbar being connected to the respective power connection (214, 216), wherein the busbar (224, 226) of the positive DC power connection (214) and of the negative DC power connection (216) extends along a direction parallel to a main plane of the substrate between a printed circuit board (222) and the substrate, wherein the busbar (224, 226) has a top side (225) and a bottom side (223),
wherein the busbar (224, 226) of the positive DC power connection (214) and/or of the negative DC power connection (216) is at least partially covered with a current-insulating coating (212), wherein the current-insulating coating (212) is fixed to the top side of the printed circuit board (222) and is fixed to the bottom side of an inverter housing (234) of the electric drive, wherein a screw connection is provided to fix the busbar (224, 226) of the positive DC power connection (214) and/or of the negative DC power connection (216) to the inverter housing (234), and a hot-swaged plastic dome (2121) is provided to connect the printed circuit board (222) to the busbar (224, 226) of the positive DC power connection (214) and/or of the negative DC power connection (216), wherein the hot-swaged plastic dome is a plastic dome that is designed to extend out of the current-insulating coating through an opening (2222) in the printed circuit board (222).

2. Half-bridge (210) according to Claim 1, wherein the current-insulating coating (212) is a prefabricated component, which comprises a recess for receiving the busbar (224, 226) of the positive DC power connection (214) and/or of the negative DC power connection (216).

3. Half-bridge (210) according to Claim 1, wherein the current-insulating coating (212) is an injection-moulded part, which is injected onto the busbar (224, 226) of the positive DC power connection (214) and/or of the negative DC power connection (216) by means of an injection-moulding process.

4. Half-bridge (210) according to one of the preceding claims, wherein the top side and/or the bottom side of the busbar (124, 224, 126, 226) is covered with the current-insulating coating (112, 212).

5. Half-bridge (210) according to one of the preceding claims, wherein the busbar (124, 224, 126, 226) covered with the current-insulating coating (112, 212) has two surface sections, which enclose an angle with one another, along the direction parallel to the main plane of the substrate.

6. Half-bridge (210) according to one of the preceding claims, wherein only one of the two busbars (224, 226) is covered with the current-insulating coating (212), wherein the other of the two busbars (224, 226) is coated on a side facing away from the substrate with an insulating thin-layer film (227).

7. Power module for an inverter, comprising at least three half-bridges (210) according to one of the preceding claims.

8. Inverter for an electric drive of an electric vehicle or a hybrid vehicle, comprising a power module according to Claim 7.

## Revendications

1. Demi-pont (210) pour un entraînement électrique d'un véhicule électrique ou d'un véhicule hybride, le demi-pont (110A-C) comprenant un substrat, des éléments de commutation à semi-conducteur, des connexions de puissance (214, 216) et des connexions de signaux (220), les connexions de puissance (214, 216) comprenant une connexion de puissance DC positive (214), une connexion de puissance DC négative (216) et une connexion de puissance AC,
dans lequel les connexions de signaux (220) sont connectées électriquement aux éléments de commutation à semi-conducteur de telle sorte que les éléments de commutation à semi-conducteur puissent être commutés par l'intermédiaire des connexions de signaux (220), dans lequel les connexions de puissance (214, 216) sont connectées électriquement aux éléments de commutation à semi-conducteur de telle sorte que les éléments de commutation à semi-conducteur permettent ou interrompent une transmission de puissance électrique entre les connexions de puissance (214, 216),
dans lequel une barre omnibus respective (224, 226) est prévue pour la connexion de puissance DC positive (214) et la connexion de puissance DC négative (216) pour une mise en contact externe, ladite barre omnibus étant connectée à la connexion de puissance respective (214, 216), dans lequel la barre omnibus (224, 226) de la connexion de puissance DC positive (214) et de la connexion de puissance DC négative (216) s'étendant le long d'une direction parallèle à un plan principal du substrat entre une carte de circuit imprimé (222) et le substrat, dans lequel la barre omnibus (224, 226) présente une face supérieure (225) et une face inférieure (223),
dans lequel la barre omnibus (224, 226) de la connexion de puissance DC positive (214) et/ou de la connexion de puissance DC négative (216) est au moins partiellement recouverte d'un revêtement d'isolation du courant (212), dans lequel le revêtement d'isolation du courant (212) est fixé sur la face supérieure à la carte de circuit imprimé (222) et fixé sur la face inférieure à un boîtier d'onduleur (234) de l'entraînement électrique, dans lequel un assemblage vissé est prévu pour fixer la barre omnibus (224, 226) de la connexion de puissance DC positive (214) et/ou de la connexion de puissance DC négative (216) au boîtier d'onduleur (234), et un dôme en plastique estampé à chaud (2121) est prévu pour connecter la carte de circuit imprimé (222) à la barre omnibus (224, 226) de la connexion de puissance DC positive (214) et/ou de la connexion de puissance DC négative (216), dans lequel le dôme en plastique estampé à chaud est un dôme en plastique qui est conçu pour s'étendre hors du revêtement d'isolation du courant à travers une ouverture (2222) de la carte de circuit imprimé (222).

2. Demi-pont (210) selon la revendication 1, dans lequel le revêtement d'isolation du courant (212) est un composant préfabriqué qui comprend un évidement permettant de recevoir la barre omnibus (224, 226) de la connexion de puissance DC positive (214) et/ou de la connexion de puissance DC négative (216).

3. Demi-pont (210) selon la revendication 1, dans lequel le revêtement d'isolation du courant (212) est une pièce moulée par injection qui est moulée par injection sur la barre omnibus (224, 226) de la connexion de puissance DC positive (214) et/ou de la connexion de puissance DC négative (216).

4. Demi-pont (210) selon l'une des revendications précédentes, dans lequel la barre omnibus (124, 224, 126, 226) est recouverte sur la face supérieure et/ou sur la face inférieure par le revêtement d'isolation du courant (112, 212).

5. Demi-pont (210) selon l'une des revendications précédentes, dans lequel la barre omnibus (124, 224, 126, 226) recouverte par le revêtement d'isolation du courant (112, 212) présente deux parties de surface formant un angle l'une par rapport à l'autre le long de la direction parallèle au plan principal du substrat.

6. Demi-pont (210) selon l'une des revendications précédentes, dans lequel une seule des deux barres omnibus (224, 226) est recouverte par le revêtement d'isolation du courant (212), dans lequel l'autre des deux barres omnibus (224, 226) est recouverte sur une face tournée à l'opposé du substrat par un film à couche mince isolant (227).

7. Module de puissance pour un onduleur, comprenant au moins trois demi-ponts (210) selon l'une des revendications précédentes.

8. Onduleur pour un entraînement électrique d'un véhicule électrique ou d'un véhicule hybride, comprenant un module de puissance selon la revendication 7.
